# EUROPEAN PATENT APPLICATION

(11) **EP 0 569 221 A2**
(43) Date of publication of application: **10.11.1993**
(21) Application number: 93303476.1
(22) Date of filing: 05.05.1993
(51) Int. Cl.: H01L 27/02

(54) **Integrated ultra low leakage high voltage protection circuit**

(30) Priority: 05.05.1992 US 878651
(71) Applicant: XEROX CORPORATION, Rochester New York 14644 (US)
(72) Inventor: Mojardi, Mohamad M., Los Angeles, California (US); Lao, Guillermo, Hawthorn, California (US); Sumida, Dale, Los Angeles, California (US)
(74) Representative: Goode, Ian Roy

(57) **Abstract**

An integrated linear high voltage device for handling high voltages such as 1700 volts. The high voltage device of this invention has an n-channel or a p-channel MOSFET (12) with a floating substrate (18) (no connection to ground or to any power supply). The device of this invention also has an ultra low leakage input protection circuit (25) comprising two Zener diodes (D₁,D₂) and a resistor (R₂) which makes the device operable in conjunction with highly sensitive circuits which require ultra low input leakage current.

## Description

This invention relates to an integrated linear high voltage device with ultra low capacitance.

It is an object of this invention to provide an ultra low D.C. leakage input protection circuit for such an integrated linear high voltage device, wherein both the protection circuit and the device can be fabricated on one chip.

According to the present invention, there is provided an integrated linear high voltage device comprising a metal oxide silicon field-effect transistor; having a substrate, a source, a drain and a gate; wherein said substrate of said transistor is floating; and said source of the transistor is electrically connected to said substrate.

A device in accordance with the invention will now be described, by way of example, with reference to the accompanying drawings wherein:
**Figure** **1** is a circuit diagram of an integrated linear high voltage device;
**Figure** **2** is a circuit diagram of an integrated linear high voltage device with an ultra low D.C. leakage input protection circuit; and
**Figure** **3** is a circuit diagram of an alternative embodiment of a device in accordance with the invention.

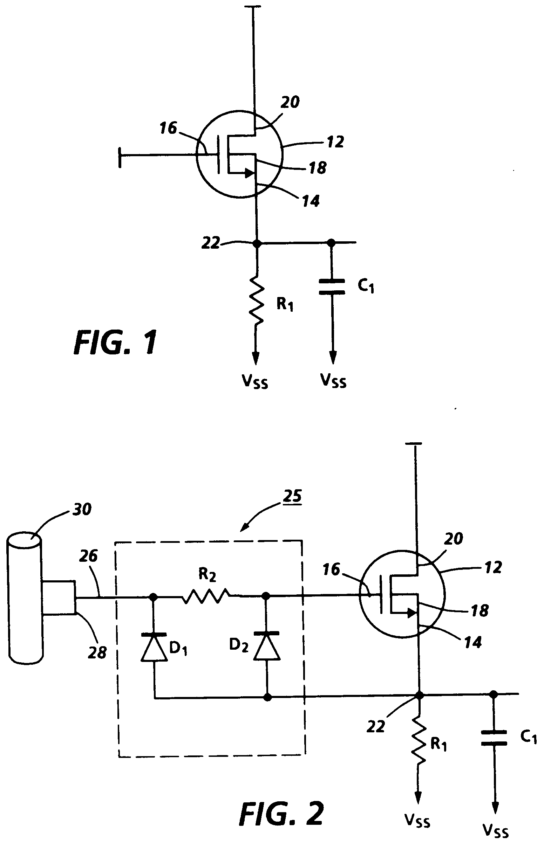

Referring to Figure 1, an integrated linear high voltage device is shown. The source **14** of a high voltage n-channel MOSFET (metal oxide silicon field-effect transistor) **12** is connected to a power supply **V**_{**SS**} (substrate power supply) through resistor **R₁**. Hereinafter, where the word transistor is used, it should be assumed that it refers to an n-channel MOSFET. The **V**_{**SS**} ranges between **0** volts to **-1700** volts. The drain 20 is kept at **0** volts with respect to **V**_{**SS**}. An important feature of this invention is that the substrate **18** of the transistor **12** is "floating". "Floating" as used herein shall mean that the substrate **18** is neither connected to any power supply nor is it grounded. By having the substrate **18** floating, the source 14 can be connected (node **22**) to the substrate **18** generating a linear source follower transistor. This configuration takes the transistor **12** into its saturation region which allows the circuit to operate with a gain of approximately **1** over the whole voltage range from zero to **V**_{**SS**}. This device has a high linearity and high precision. In order to achieve linearity, "bodyeffect" should be eliminated. The "bodyeffect", which is the potential between the substrate **18** of the transistor **12** and the source **14**, causes a shift in the threshold voltage of the transistor and increases the nonlinearity. In this configuration, the source **14** of the transistor **12** is connected to its substrate **18** which is floating, to eliminate the bodyeffect.

It is very desirable to obtain optimum linearity. In order to achieve the optimum linearity, it is desirable to use a high voltage resistor **R₁** which contributes to linearity. The resistor eliminates the effect of electric fields associated with the bias voltages of substrate (the substrate bias voltages) on the charge carriers densities within the resistive blocks.

Even though this device enjoys a high linearity, there is a problem in protecting the transistor at high voltages. When a sudden input voltage is applied to the gate **16** of the transistor **12**, the source capacitance **C₁**, which can be modeled between the node **22** and **V**_{**SS**}, starts charging up. In the worst case, before applying the input voltage, the source voltage, which is connected to the substrate, is at **V**_{**SS**} When the source capacitance **C₁** starts charging up, the source voltage (node **22**) starts increasing and in theory the source voltage eventually should rise to a voltage close to the input voltage. However, since the charging rate of the source capacitance **C₁** is slow the source voltage can not increase to the input voltage rapidly and therefore, initially the voltage difference between the gate **16** and the source **14** can be very large (for instance **-1700** volts). At this range of voltage difference, the dielectric oxide of the gate **16** ruptures and permanently breaks down which destroys the transistor **12**. The breakdown occurs at voltages between **60** to **90** volts. To protect the transistor **12** from destruction by high voltages a protection circuit is needed.

Traditionally, protection circuits have some D.C. input leakage currents. Hereinafter, the D.C. input leakage current is referred to as leakage current. Usually, the leakage current is not a problem in many circuit designs. However, in some sensitive circuit designs such as contacting electrostatic voltmeters, the leakage current is a major problem. In a contacting electrostatic voltmeter, the contacting means should not draw any leakage current. For example, referring to Figure **2**, in a steady state case, when a contacting means **28** contacts the surface of a photoreceptor **30** in a xerographic printer, the contacting means **28** should not disturb the charge pattern of an image on the photoreceptor. If an electrostatic voltmeter with a leakage current contacts a photoreceptor **30**, the charges of the image on the photoreceptor will start moving into the electrostatic voltmeter through the leakage current and therefore, the image smears.

To avoid this problem the leakage current should be lowered as much as possible. In highly sensitive circuits such as PH meters or electrostatic voltmeters, there is a great need to lower the leakage input current to a range of picoamperes or preferably femtoamperes.

The protection circuit of this design overcomes the above problem and has a leakage current in the range of picoampere. The floating substrate **18** of the high voltage transistor **12** is the key element in offering a technique for designing an on chip protection circuit. This is accomplished by utilizing small on chip Zener diodes which have ultra low input leakage current.

The protection circuit **25** of this invention consists of two Zener diodes **D₁** (**30,000** µm²) and **D₂** (**18,000** µm²) with both diodes having a breakdown voltage ranging between **18V** to **25V**. The protection circuit **25** also has a resistor **R₂** with a resistance ranging between **4** kilohm to **20** kilohm. Resistor **R₂** is connected between the cathodes of diodes **D₁** and **D₂**. The cathode of diode **D₁** is also connected to the input line **26** and the cathode of diode **D₂** is also connected to the gate **16** of transistor **12**. The anodes of diodes **D₁** and **D₂** are both connected to the source **14** of the transistor **12**. In this configuration, the voltage at the input line **26** can vary between **0** volts to **-1700** volts and any input voltage beyond the range of **-18V** to **-25V** will be clamped by the diodes **D₁** and **D₂**. Compared to the applied voltage (**-1700** volts), the sizes of these Zener diodes are very small. This is made possible due to the floating substrate of transistor **12**. Since the source **14** is connected to a floating substrate **18** the voltage difference between the gate **16** and the source **14** can not be more than the Zener break down voltage (**18V** to **25V**) of a single diode. Therefore, in this invention two small diodes which can handle a voltage difference in the range of their breakdown voltages (**18V** to **25V**) are used. In a conventional transistor where the substrate is connected to **V**_{**SS**}, and the source is connected to the substrate, the voltage difference between the input with **0** volts and the source voltage would be **-1700** volts. To clamp this range and withstand the voltage, larger diodes (**100** times larger than the diodes of this embodiment) in a more complicated scheme than the protection circuit **25** would be used to protect the device. It should be understood that 'larger diodes' refers to diodes with larger junction areas. However, due to the floating substrate of transistor **12**, much smaller diodes are used in the design of the protection circuit **25** of this invention. Consequently, the protection circuit is a compact circuit which can be fabricated on one chip with the integrated linear high voltage device.

When any voltage higher than the Zener breakdown voltage (**18V** to **25V**), is applied to the input line **26**, the diodes **D₁** and **D₂** will clamp the input voltage. By applying a high voltage to the input line **26**, the source capacitance **C₁**, which is between the floating node (source connected to the substrate) and **V**_{**SS**}, starts charging up. While the source capacitance **C₁** is charging up, the Zener diodes **D₁** and **D₂** are in their breakdown region. Diode **D₁**, which is larger than diode **D₂**, receives the high input voltage and clamps it down.

Each diode has a corresponding series resistance. While the diodes are in their breakdown regions, the current passing through the diodes causes a corresponding voltage across the series resistance. The sum total of the breakdown voltage and the voltage drop across the series resistance appears between the two terminals of diodes **D₁** and **D₂** as shown in **Figure 2.** Diode **D₁** is designed to have a current in the range of **2** ampere and also has a series resistance ranging between **0** and **30** ohm. Diode **D₂** is designed to have a current no more than **2** milliampere and also has a series resistance ranging between **30** and **150** ohm. The current passing through the series resistance of this diode **D₁** causes a voltage in the range of **100** volts (**25** breakdown voltage + **75** across series resistance) across the diode **D₁** which is high enough to destroy the transistor in the absence of resistor **R₂** and diode **D₂**. By having resistor **R₂** and diode **D₂**, the current passing through resistor **R₂** causes a voltage drop across the resistor **R₂** which in turn lowers the input voltage to the range of **30** volts (**25** breakdown voltage + **5** across series resistance). This lowered voltage which is applied to diode **D₂** is still higher than the Zener breakdown voltage and therefore, puts this diode into its breakdown region. Since diode **D₂** is smaller than diode **D₁** and diode **D₂** is clamping a lower voltage, it draws less current. The current passing through the series resistance of diode **D₂** causes a voltage across this diode which is low enough not to harm the transistor.

The current passes through the diodes **D₁** and **D₂** until the source capacitance **C₁** charges up to a voltage, whereby the difference between this voltage (source voltage) and the input voltage becomes less than the Zener breakdown voltage which in turn turns off the diodes **D₁** and **D₂**. When the diodes are turned off they have an input leakage current in the range of picoampere. This ultra low leakage current is due to the small size of the diodes used in this design. The leakage current of a diode is proportional to its junction area and the smaller the junction area, the smaller the leakage current. Since in this design much smaller diodes are used, the leakage current is very very low.

The protection circuit, as is obvious from its name, is designed to protect the device from high input voltages. Once the source capacitance **C₁** of the device is charged up, the two diodes **D₁** and **D₂** will turn off and they stay inactive as long as there is no sudden voltage change in the input voltage or as long as the power to the device is not turned off. For example, in a system such as a contacting electrostatic voltmeter, as shown in Figure **2**, initially when the system is turned on, the diodes **D₁** and **D₂** start to conduct until the source capacitance **C₁** charges up and then the protection circuit becomes inactive. After the protection circuit becomes inactive, an image pattern can be sent to the photoreceptor **30** since the leakage current of the protection circuit **25** is ultra low. When the contacting means **28**, which is electrically connected to this protection circuit **25** through the input line **26**, contacts the photoreceptor **30**, it does not draw current to smear the image on the photoreceptor. The protection circuit **25** will stay inactive and does not affect the image on the photoreceptor unless a drastic change on the input voltage occurs due to the malfunction of the system or due to an external factor. At any sudden or drastic change of input voltage the protection circuit **25** turns on to protect the device.

Initially when the system is turned on, if the rate of voltage increase at input is similar to the charging rate of capacitance **C₁**, the protection circuit stays inactive. The inactivation is due to the fact that the voltage of node **22** follows the increase of the input voltage since the capacitance **C₁** charges up fast. Thus, the voltage difference between the gate and the source of the transistor stays at less than the Zener breakdown voltage of either diodes which keeps the diodes inactive. The protection circuit is also inactive during a large change of charge on the photoreceptor since the rate of the change of the charge on the photoreceptor **30** (the rate of the input change of the protection circuit **25**) and the rate of the change of the charge of capacitance **C₁** are similar.

It should also be noted that the integrated linear high voltage device of this invention, disclosed in Figure **1,** can be used in combination with other circuits without a protection circuit for purposes other than high voltage applications or in designs where the voltage can be lowered by some other circuits.

The high voltage n-channel device of this invention, in its present design with **3** micron ultra high voltage CMOS technology, is capable of handling negative voltage differences up to **1700** volts. Since the Vss is at **-1700** volts and the input voltage can vary between **0** volts to **-1700** volts, the absolute value of the maximum voltage difference is **1700** volts. A p-channel MOSFET with the same geometry of n-channel MOSFET handles positive voltage differences with a lower absolute value. For example, if the Vss for a p-channel MOSFET is **+** **1200** volts, then the input voltage can vary between **0** volts to + **1200** volts and therefore, the absolute value of the maximum voltage difference is **1200** volts.

If one desires to use a p-channel MOSFET and be able to handle voltage differences similar to the voltage differences that an n-channel MOSFET handles, regardless of the polarity of the voltage differences, the p-channel MOSFET can be designed with larger geometries. A p-channel MOSFET with larger geometries can handle higher positive voltage differences. It should be understood that the integrated linear high voltage device of this invention disclosed in Figure **1** utilizes both enhancement and depletion modes of both n-channel and p-channel MOSFETs. Furthermore, it should also be understood that the voltage handling capability of both the n-channel MOSFET and the p-channel MOSFET can be improved by changing the parameters, such as higher resistivity substrate material or lower doping concentration of the junctions, or by using any technology which can produce higher voltage MOS transistors. In this instance the voltage difference handled by either the n-channel MOSFET or the p-channel MOSFET would be substantially beyond ± **1700** volts.

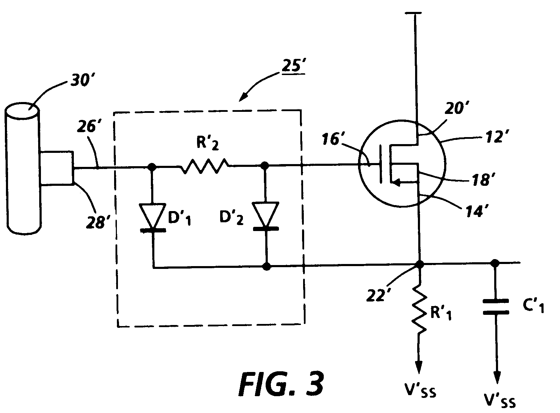

Figure 3shows an alternative embodiment of this invention using a p-channel MOSFET **12'**. Those elements which operate in the same manner as disclosed in the description of Figure **2** are designated by the same reference numerals, only with a prime (') affixed thereto. As shown in Figure **3**, when a p-channel MOSFET is used, the polarity of the diodes **D₁'** and **D₂'** in the protection circuit **25'** are reversed. Resistor **R₂'** is connected between the anodes of diodes **D₁'** and **D₂'.** The anode of diode **D₁'** is also connected to the input line **26'** and the anode of diode **D₂'** is also connected to the gate **16'** of the p-channel MOSFET **12'**. The cathodes of diodes **D₁'** and **D₂'** are both connected to the source **14'** of the p-channel MOSFET **12'**. In this configuration, since the input voltage on line **26'** is in the positive range, the diodes **D₁** and **D₂** clamp any voltage beyond the range of **+** **18V** to **+** **25V**.

## Claims

1. An integrated linear high voltage device comprising a metal oxide silicon field-effect transistor (12) having a substrate (18), a source (14), a drain (20) and a gate (16); wherein said substrate (18) of the transistor is floating; and said source (14) of the transistor is electrically connected to said substrate.

2. The device as recited in claim 1, further comprising:
a power supply (Vₛₛ); and
a resistive means (R₁) electrically interposed between and electrically connected to said power supply and said source (14) of said transistor.

3. The device as recited in claim 1 or claim 2, further comprising:
means for applying a voltage (Vₛₛ) to said transistor ranging from 0 to a given voltage; and
means (25) for clamping a voltage range which is beyond said given voltage.

4. The device as recited in claim 3, wherein said device, said voltage applying means and said voltage clamping means are all on the same chip and all have a common substrate.

5. The device as recited in claim 3 and claim 4, wherein said given voltage is in the range between -18 and 25 volts, or between + 18 and + 25 volts, for either an n-channel or a p-channel transistor, respectively.

6. The device as recited in any one of claims 3 to 5, wherein the range beyond said given voltage is between -18 and 1700 volts, or + 18 and + 1700 volts, for either an n-channel or a p-channel transistor, respectively.

7. The device as recited in any one of claims 1 to 6, wherein
said transistor is n-channel; and including
a protection means (25) comprising an input (26), a resistor (R₂), a first Zener diode (D₁) and a second Zener diode (D₂);
each of said Zener diodes having a cathode and an anode;
the cathode of said first Zener diode and the cathode of said second Zener diode being electrically connected to each other through said resistor (R₂);
the cathode of said first Zener diode being electrically connected to said input (26) of said protection means and the cathode of said second Zener diode being electrically connected to said gate (16) of said transistor; and
the anodes of said first and second Zener diodes both being electrically connected to said source (14) of said transistor for limiting the voltage difference between said gate (16) of said transistor and said source (14) of said transistor to a voltage not exceeding the breakdown voltage of said first and said second Zener diodes.

8. The device as recited in any one of claims 1 to 6, wherein
said transistor is p-channel; and including
a protection means (25) comprising an input (26), a resistor (R₂), a first Zener diode (D₁) and a second Zener diode (D₂);
each of said Zener diodes having a cathode and an anode;
the anode of said first Zener diode and the anode of said second Zener diode being electrically connected to each other through said resistor (R₂);
the anode of said first Zener diode being electrically connected to said input (26) of said protection means and the anode of said second Zener diode being electrically connected to said gate (16) of said transistor;
the cathodes of said first and second Zener diodes being electrically connected to said source (14) of said transistor for limiting the voltage difference between said gate (16) of said transistor and said source (14) of said transistor to a voltage not exceeding the breakdown voltage of said first and said second Zener diodes.

9. The device as recited in claim 7 or claim 8, wherein said first diode (D₁) has a series resistance ranging between 0 and 30 ohm and said second diode (D₂) has a series resistance ranging between 30 and 150 ohm.
